(19) Europäisches Patentamt
European Patent Office
Office européen des brevets

(11) **EP 4 431 643 A1**

(12) **EUROPEAN PATENT APPLICATION**

(43) Date of publication:
**18.09.2024 Bulletin 2024/38**

(51) International Patent Classification (IPC):
*C30B 23/06* (2006.01)    *C30B 29/36* (2006.01)

(21) Application number: **23161963.6**

(52) Cooperative Patent Classification (CPC):
**C30B 29/36; C30B 23/066**

(22) Date of filing: **15.03.2023**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **SiCrystal GmbH**
**90411 Nürnberg (DE)**

(72) Inventors:
• **Schuh, Philipp**
**90411 Nürnberg (DE)**

• **Ecker, Bernhard**
**90411 Nürnberg (DE)**
• **Müller, Ralf**
**90411 Nürnberg (DE)**
• **Stockmeier, Matthias**
**90411 Nürnberg (DE)**
• **Vogel, Michael**
**90411 Nürnberg (DE)**

(74) Representative: **Grünecker Patent- und
Rechtsanwälte
PartG mbB
Leopoldstraße 4
80802 München (DE)**

(54) **SUBLIMATION SYSTEM AND METHOD OF GROWING AT LEAST ONE SINGLE CRYSTAL**

(57)    The present invention relates to systems and methods for growing bulk semiconductor single crystals, and more specifically, for growing bulk semiconductor single crystals, such as silicon carbide, based on physical vapor transport. The sublimation system comprises a crucible (102) having a longitudinal axis (120) and a sidewall (116) extending along the longitudinal axis (120), wherein the crucible comprises a fixing means for at least one seed crystal (110) and at least one source material compartment (104) for containing a source material (108), and a heating system being formed to generate a temperature field around a circumference of the crucible along the longitudinal axis of the crucible, wherein the crucible (102) comprises at least one first heat radiation cavity (118), which is arranged opposite to the fixing means and adjacent to the source material compartment (104), the first heat radiation cavity (118) being closed on all of its sides.

Fig. 1

EP 4 431 643 A1

**Description**

The present invention relates to systems and methods for growing bulk semiconductor single crystals, and more specifically, for growing bulk semiconductor single crystals, such as silicon carbide, based on physical vapor transport.

Silicon carbide (SiC) is extensively used as a semiconductor substrate material for electronic components in a wide range of applications, such as power electronics, radio frequency, and light emitting semiconductor components.

Physical vapor transport (PVT) is generally used for growing bulk SiC single crystals, and in particular, for commercial purposes. The SiC substrates are produced by cutting slices from the bulk SiC crystal (for e.g. using wire saws) and finishing the slice surface with a sequence of polishing steps. The finished SiC substrates are employed in the manufacturing of semiconductor components, such as in epitaxial processes where thin monocrystalline layers of a suitable semiconductor material (e.g., SiC, GaN) are deposited onto the SiC substrate. The characteristics of the deposited monolayers and the components produced therefrom depend crucially on the quality and homogeneity of the underlying substrate. For this reason, the outstanding physical, chemical, electrical and optical properties of SiC makes it a preferred semiconductor substrate material for power device applications.

PVT is a crystal growing method that essentially involves sublimation of a suitable source material followed by re-condensation at a seed crystal, where the formation of the single crystal takes place. The source material and seed crystal are placed inside a growth structure, where the source material is sublimed by heating. The sublimed vapor then diffuses in a controlled manner due to a temperature field having a gradient established between source material and seed crystal and deposits onto the seed to grow as a single crystal.

Conventional PVT-based growth systems generally employ either inductive or resistive heating systems for subliming the source material. In both cases, the core of the PVT-based growth system is the so-called reactor. The growth structure, essentially comprising a crucible and a fixing means for the seed crystal and conventionally made of graphite and carbon materials, is placed in the interior of the reactor and heated by either induction coils arranged outside the reactor or by resistive heaters arranged outside or inside the reactor. The temperature within the growth structure is measured by one or more pyrometers or by one or more thermocouples installed close to an overture of the growth structure. The vacuum-sealed reactor is evacuated by one or more vacuum pumps and supplied with inert or doping gases via one or more gas feeds to create a controlled gas (gas mixture atmosphere). All process parameters (pressure, temperature, gas flow, etc.) can be adjusted, controlled and stored by a computer-operated system controller, which communicates with all involved components (for e.g. inverter, pyrometer, vacuum control valve, mass flow control (MFC), and pressure gauges).

In the case of inductively-heated PVT systems, the reactor usually includes one or more glass tubes, which are optionally cooled with water and provided at both ends with flanges to seal the interior of the reactor against the atmosphere. An example of such an inductively heated PVT system is described in patent US 8,865,324 B2. Fig. 9 illustrates such a conventional inductively heated PVT system 800.

The growth arrangement 800 comprises a growing crucible 802, which contains an SiC supply region 804 and a crystal growth region 806. Powdery SiC source material 808, which is poured as a pre-finished starting material before the beginning of the growth process into the SiC supply region 804 of the growing crucible 802, for example, is located in the SiC supply region 804. The source material 808 may also be densified or be at least partly consist of solid material in order to enhance the density of the source material 808.

A seed crystal 810 is provided on an inner wall opposing the SiC supply region 804 of the growing crucible 802, e. g. on its crucible lid 812, in the crystal growth region 806. The bulk SiC single crystal to be grown grows on the seed crystal 810 by deposition from an SiC growth gas phase forming in the crystal growth region 806. The growing bulk SiC single crystal and the seed crystal 810 may have approximately the same diameter.

The growing crucible 802 including the crucible lid 812 may be fabricated from an electrically and thermally conductive graphite crucible material. Around it is arranged a thermal insulation (not shown in the Figure), which may comprise, for example, a foam-like graphite insulation material, the porosity of which is, in particular, higher than that of the graphite crucible material.

The thermally insulated growing crucible 802 is placed inside a tubular container 814, which may be configured as a quartz glass tube and forms an autoclave or reactor. An inductive heating device in the form of a heating coil 816 is arranged around the container 814 to heat the growing crucible 802. The growing crucible 802 is heated by the heating coil 816 to growth temperatures of more than 2000 °C, in particular to about 2200 °C. The heating coil 816 inductively couples an electric current into an electrically conductive crucible wall (the so-called susceptor) of the growing crucible 802. This electric current flows substantially as a circulating current in the peripheral direction within the circular and hollow cylindrical crucible wall and in the process heat the growing crucible 802. The susceptor can be made from graphite, TaC, WC, Ta, W, or other refractory metals. The primary purpose of the susceptor is to provide a heat source for inside of the crucible 802. When the susceptor is heated with induction, the surface of the susceptor reaches a high temperature, and the temperature is then transferred to the inside of the crucible 802 through conduction and/or radiation.

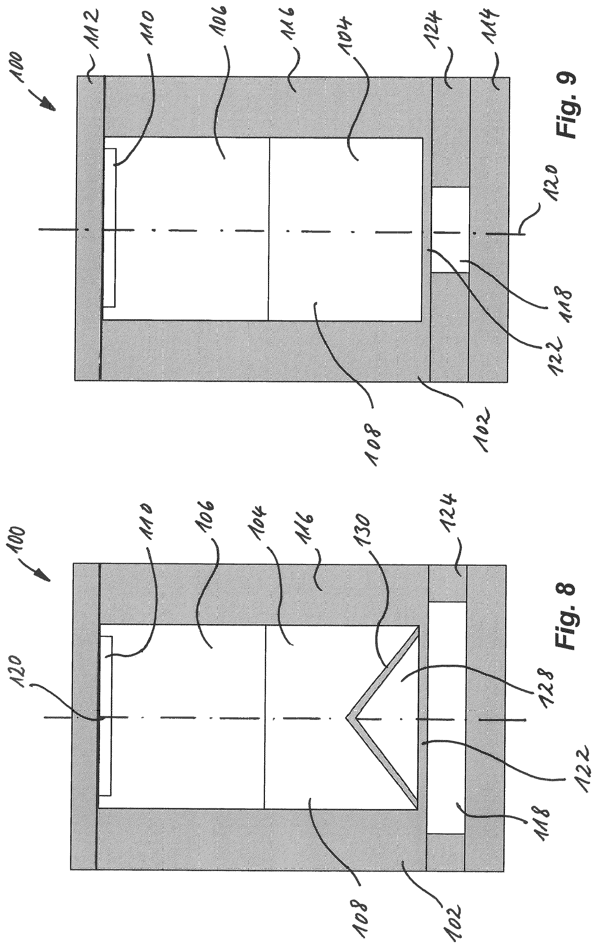

As mentioned above, the induction coil 816 is mounted outside the glass tube 814 and is usually surrounded by a Faraday cage (not visible in the drawing) forming an electromagnetic shielding to shield the electromagnetic radiation. As shown in the example of Fig. 9, the induction coil 816 may be wound with equidistant windings.

Furthermore, in conventional resistively-heated PVT systems, the heating resistive elements are mounted inside the reactor. In case the reactor is made of metal, refractory metals and/or graphite, it can be cooled by water or air. Examples of resistively-heated PVT systems are described in published patent applications US 2016/0138185 A1 and US 2017/0321345 A1.

For the growth of a high-quality crystal, a homogeneous coupling of the heat into the growth crucible in the radial direction is considered as being of enormous importance. By coupling the heat as homogeneously as possible, the crystal should also grow as homogeneously and symmetrically as possible. Among other things, this should prevent the formation of threading screw dislocations (TSD) and threading edge dislocations (TED), also called step dislocations, whose formation is favored by an inhomogeneous, asymmetrical heat distribution and the associated inhomogeneous, asymmetrical growth.

Consequently, PVT growth systems have to heat up the inside of the crucible with a temperature field that is as homogeneous as possible in a radial direction and providing a defined temperature-gradient in an axial direction, in order to set a driving force for the sublimed gas species moving to the seed and the growing single-crystal. In known PVT systems, the reactor structures, which are usually made of graphite or a comparable material, are heated from the wall region, creating a temperature gradient from the exterior to the interior of the crucible. As a result, the conversion of the SiC source decreases from the outside to the inside.

Thereby, a region is created in the source compartment where the temperature is no longer sufficient for a complete conversion and only recrystallization of source material occurs, which thus no longer contributes anything to crystal growth. This effect is enhanced by the transformation of the sintered SiC powder into a carbon sponge, caused by the different partial pressures of silicon and carbon-rich gas species. The carbon sponge reduces its thermal conductivity with increasing growth time and increasingly acts as an insulator between the heater and the source material. To counteract this effect, the source material must be heated more strongly for further growth. Nevertheless, a residue of unreacted material often remains. Unreacted or thermally isolated source material thus leads to a greatly reduced yield and thus to increased costs.

With increasing crystal diameter, a successive increase in the reactor size and the introduced crucible is also necessary. Due to the effects described above, the effective usability of the introduced source material is further reduced because of the increasing diameter of the reactor.

Due to the different partial pressures of the gas species containing Si and C, the chemical composition of the source material contributing to crystal growth changes. If the processes described above mean that fresh material is no longer available for crystal growth, the chemical composition of the gas phase also changes, which has an influence on crystal growth and thus leads to losses in crystal quality.

The reduction of the thermal conductivity or the graphitization of the source material is inevitable in the PVT process as it is used for the economic production of SiC single crystals in order to produce crystals with high diameters or corresponding lengths. A reduction of the negative effect of the non-conversion of the SiC containing source can be achieved for example by the introduction of a local heating element.

For instance, from the Chinese utility model CN210974929U, it is known to insert a solid rod inside the source reservoir for this purpose.

The insertion of this local heating element is intended to prevent recrystallization of the source material at the lower end of the crucible bottom, as well as to increase the thermal conduction towards the center of the source reservoir. As a result, a larger volume is homogeneously heated and graphitization of the source is locally reduced. In this document, the heating of the crucible is made possible by an induction coil. The hottest point is thus at the outer edge of the crucible and the rod inside the reservoir serves as an extension of the heating element by means of thermal conduction, by transporting the heat axially and radially from the wall of the crucible to the center of the powder reservoir.

The shape of such an additional conduction heater can also vary, as shown in the Japanese patent specification JP6859800B2. The geometrical variations shown in this document correspond to the same principle as in the Chinese utility model CN210974929U. According to JP6859800B2, a cylinder open on one side with a recess at the lower end located at least in the centric part of the bottom is proposed. In addition, a complementary conical component is introduced into this recess.

According to the patent specification JP6859800B2, only the outer cylinder walls are heated via induction or resistance heating, and the heat is conducted into the powder volume via the additional conical component.

Another advantage of such a setup is the possibility of removing the recrystallized source material at the bottom of the crucible, thus increasing the lifetime of the crucible material.

Another known approach to optimize the reaction of the source material is described in the Japanese patent JP6501494B2. Here, a combination of two additional disc shaped components (a heat generating member and a heating auxiliary portion) is placed underneath the structure filled with source material. Because the diameter of the heat generating member is significantly smaller than that of the heating auxiliary portion, the resulting diameter difference is compensated by installing a heat insulating material.

Due to the increased diameter of heat generating member, the induction coil can couple more efficiently and thus heats up more than the auxiliary heating member and the crucible. Due to the thermal conduction, the heat generating member thus acts as a resistance heater, transporting the temperature locally to the center and thus reducing or even preventing recrystallization of the source material.

The present invention has been made in view of the shortcomings and disadvantages of the prior art, and an object thereof is to provide a system for growing single crystals of a semiconductor material by physical vapor transport (PVT) and a method of manufacturing same with improved single crystal quality and in a cost effective manner, utilizing the employed source material more efficiently.

This object is solved by the subject matter of the independent claims. Advantageous embodiments of the present invention are subject matter of the dependent claims.

The present invention is based on the idea that an improved heating efficiency can be achieved by using not only heat conduction, but-additionally and in a spatially controlled manner-heat radiation for heating the source material compartment.

In particular, the basic problem of graphitization of the source material is reduced according to the known solutions mentioned above by the introduction of local heaters based on the principle of thermal conduction. This physical principle of thermal conduction is described by Fourier's law (equation 1), where dQ/dt is the heat power (also called heat flux), $\lambda$ is the thermal conductivity, A is the area through which heat flows, d is the distance of the temperature difference, and $\Delta T$ is the temperature difference between the hotter and colder surfaces:

$$\frac{dQ}{dt} = \lambda * A * \frac{\Delta T}{d} \qquad (1)$$

The aim of the optimizations described above for the existing solutions is to significantly reduce the temperature difference between the wall and the center of the structure, which is usually made of graphite.

In contrast thereto, the present disclosure is based on the idea of circumventing the limitations of thermal conduction by using thermal radiation. The radiant heat power is described by the Stefan-Boltzmann law (equation 2). Thereby $\varepsilon$ is the emissivity of the radiating surface, $\sigma$ the Stefan-Boltzmann constant, $A$ the surface area and $T$ the (absolute) temperature of the radiating body:

$$\frac{dQ}{dt} = \varepsilon * \sigma * A * T^4 \qquad (2)$$

The Stefan-Boltzmann law states that the radiant power of an object in thermal equilibrium is proportional to the fourth power of its absolute temperature and directly proportional to its surface area.

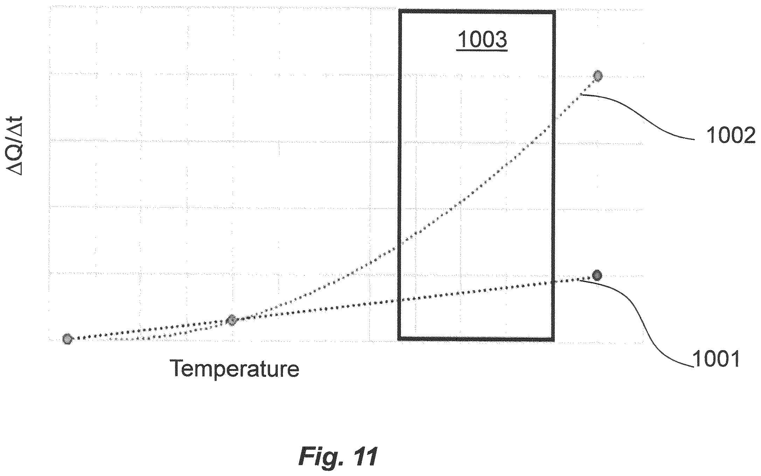

A comparison of the thermal flux caused by heat conduction (curve 1001) and caused by heat radiation (curve 1002), both as a function of the temperature, is shown in Figure 11. With the marking 1003, the temperature range, at which crystal growth is usually carried out in the PVT process, is highlighted. It is clear that in the temperature regime described, heat transport via radiation dominates over conduction. This is also illustrated by the relationships of heat power described in equation 1 and 2. As mentioned, the heat power with radiation increases with $T^4$, whereas the heat power via heat conduction increases only linearly. Thus, it can be seen that the transport of heat via radiation instead of via conduction, as in the prior art systems considered so far, is much more effective in the temperature range relevant for the growth of PVT, in particular when growing monocrystalline SiC boules.

In order to benefit from heat radiation for heating the source material compartment more efficiently and more uniformly in a radial direction, the present disclosure therefore proposes using at least one radiation cavity to transport the heat from the outside of the crucible to the center of the source material compartment.

In particular, the present disclosure provides a sublimation system for growing at least one single crystal of a semiconductor material by means of a sublimation growing process, the sublimation system comprising a crucible having a longitudinal axis and a sidewall extending along the longitudinal axis, wherein the crucible comprises a fixing means for at least one seed crystal and at least one source material compartment for containing a source material. A heating system is formed to generate a temperature field around a circumference of the crucible along the longitudinal axis of the crucible, wherein the crucible comprises at least one first heat radiation cavity, which is arranged opposite to the fixing means and adjacent to the source material compartment, the heat radiation cavity being closed on all of its sides.

The inventors of the present disclosure have found that by using a cavity with a defined design, the source material (usually a powder) can be heated more homogeneously when viewed radially in the course of the growth process, and thus a more efficient conversion takes place. Due to the additionally introduced cavity, a more efficient heat transport by radiation takes place, which leads to the fact that the heat can be conducted to the center (the symmetry axis or longitudinal axis) of the structure more efficiently. This increases the surface area heating the source material, which increases the efficiency of heat transport into the source material, which decreases during growth.

By selectively introducing at least one cavity that enables heat transport via radiation, a significantly lower temperature difference in the system can be achieved. This makes it possible to transport the temperature, which is usually hottest in the wall area of the introduced crucible structure, to the center of the crucible. A significant advantage of this is a much more efficient use of the available source material during the growth process. This also makes it possible to keep the gas phase composition constant for a longer time span during the growth process, as the source material can be heated over a larger area and more homogeneously, thus avoiding quality losses due to a changing gas phase.

A resulting advantage is a significant increase in the effectively usable mass of source material for the growth of the crystal and thus a possible increase in length as well as quality of the grown single crystal.

These advantages may specifically well be reached for growing SiC single crystals. However, it is clear that also the sublimation growth of other semiconductor crystals may benefit from the principles according to the present disclosure.

According to an advantageous example, the at least one first heat radiation cavity is delimited against the source material compartment by a separation wall which is formed from the same material as the sidewall of the crucible. This allows for an optimal mixed heat transmission by radiation and conduction. Advantageously, this separation wall is significantly thinner than the sidewalls, so that the heat radiating through the heat radiation cavity can more easily enter the source material compartment. In particular, the at least one first heat radiation cavity may be delimited against the source material compartment by a separation wall which is thinner than the sidewall of the crucible and thinner than walls that delimit the remaining sides of the first heat radiation cavity.

In order to achieve a radially uniform heat transfer into the source material compartment, a geometry of the sublimation system may be chosen, so that the first heat radiation cavity has an inner diameter across the longitudinal axis which is larger than an inner diameter of the source material compartment.

According to a further advantageous example, the first heat radiation cavity has at least one protruding compartment, which extends along the longitudinal axis into the source material compartment. Such protrusions allow to direct the heat more closely into the center of the source material compartment. Furthermore, the surface of the heating area is enlarged which in turn enhances the heating efficiency.

According to a further advantageous example, at least one second heat radiation cavity is arranged inside the source material compartment, the at least one second heat radiation cavity being separate from the first heat radiation cavity. By adding a further heat radiation cavity, an additional means for even more precisely tailoring the temperature field acting on the source material can be provided.

For instance, the at least one second heat radiation cavity may be ring shaped with a center axis of the ring coinciding with the longitudinal axis of the crucible. Furthermore, such a ring shaped second heat radiation cavity may also be combined with one or more protruding compartments at the first heat radiation cavity. Also a plurality of ring shaped second heat radiation cavities may be provided at several axial positions along the longitudinal axis of the sublimation system.

According to a further advantageous example of the present disclosure, the at least one second heat radiation cavity is delimited against the source material compartment by a slanted separation wall that includes an angle with the longitudinal axis. The slanted separation wall may be formed to either be directed towards the center of the source material compartment in the shape of a funnel. In this case, more heat is transmitted to the peripheral region by heat radiation.

Different geometric shapes of the cavity heater serve for fine tuning and/or a finer control of the heat distribution in the powder chamber. Primarily, the geometry of the crucible and the insulation structure (overall structure) serves to optimize the temperature distribution in the crystal growth space and, thus, to optimize the crystal growth. Different shapes of the cavity heater can then optimize the powder conversion decoupled from this. In other words, a new additional parameter is created, which allows a separate influence on the powder conversion without influencing the temperature distribution in the crystal growth area.

Alternatively, the at least one second heat radiation cavity may also be delimited against the source material compartment by a cone-shaped separation wall. Thus, the central region of the source material compartment is heated more efficiently.

According to a further advantageous example of the present disclosure, the first heat radiation cavity is provided with a solid pillar penetrating the first heat radiation cavity in a direction along the longitudinal axis. By this exemplary solution, the central region of the source material compartment is heated less by heat radiation and more via heat conduction.

According to a further advantageous example of the present disclosure, the heating system comprises an induction coil operable to generate an electro-magnetic field and/or a resistive heating coil, at least partly surrounding the crucible. Both heating systems create a temperature field inside the crucible. It should be noted that a distinction has to be made between the radial and the axial temperature field. The radial field, especially in the region of the growing crystal, should be as homogenous as possible. Along the longitudinal axis, a temperature gradient is needed. The axial temperature gradient is primarily the driving force for growth: the seed is colder than (powder) source, so that transport of sublimated Si and C species can occur.

It could be shown that the best results were achieved with sublimation systems in which the at least one heat radiation cavity has a volume which equals at least 1 % and at most 20 % of a volume of the source material compartment, more specifically, wherein the at least one heat radiation cavity has a volume which equals at least 1 % and at most 18 %, preferably at most 16 %, of the volume of the source material compartment.

The present disclosure further relates to a method of growing at least one single crystal of a semiconductor material by means of a sublimation growing process, the method comprising:

providing a crucible having a longitudinal axis and a sidewall extending along the longitudinal axis, fixing at least one seed crystal at a fixing means of the crucible, and filling a source material into at least one source material compartment;

generating, by means of a heating system, a temperature field around a circumference of the crucible and along the longitudinal axis of the crucible;

wherein at least a part of the heat of the temperature field is coupled via heat radiation into the source material compartment through at least one first heat radiation cavity, which is arranged opposite to the fixing means and adjacent to the source material compartment, the heat radiation cavity being closed on all of its sides.

According to an advantageous example of the present disclosure, in a plane extending across to the longitudinal axis and opposite to the seed crystal, which has a maximum temperature within the source material compartment, no temperature differences of more than 20 K, preferably no temperature differences of more than 15 K, more preferably no temperature differences of more than 10 K, occur.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. Further features and advantages will become apparent from the following more particular description of the various embodiments of the invention, as illustrated in the accompanying drawings, in which like references refer to like elements, and wherein:

FIG. 1      is a schematic sectional side view of a sublimation system according to a first example;

FIG. 2      is a schematic sectional side view of a sublimation system according to a further example;

FIG. 3      is a schematic sectional side view of a sublimation system according to a further example;

FIG. 4      is a schematic sectional side view of a sublimation system according to a further example;

FIG. 5      is a schematic sectional side view of a sublimation system according to a further example;

FIG. 6      is a schematic top view of the sublimation system according to FIG. 5;

FIG. 7      is a schematic sectional side view of a sublimation system according to a further example;

FIG. 8      is a schematic sectional side view of a sublimation system according to a further example;

FIG. 9      is a schematic sectional side view of a sublimation system according to a further example;

FIG. 10     is a schematic sectional side view of a known sublimation system;

FIG. 11     is a comparison of the heat flux via heat conduction to the heat flux via heat radiation.

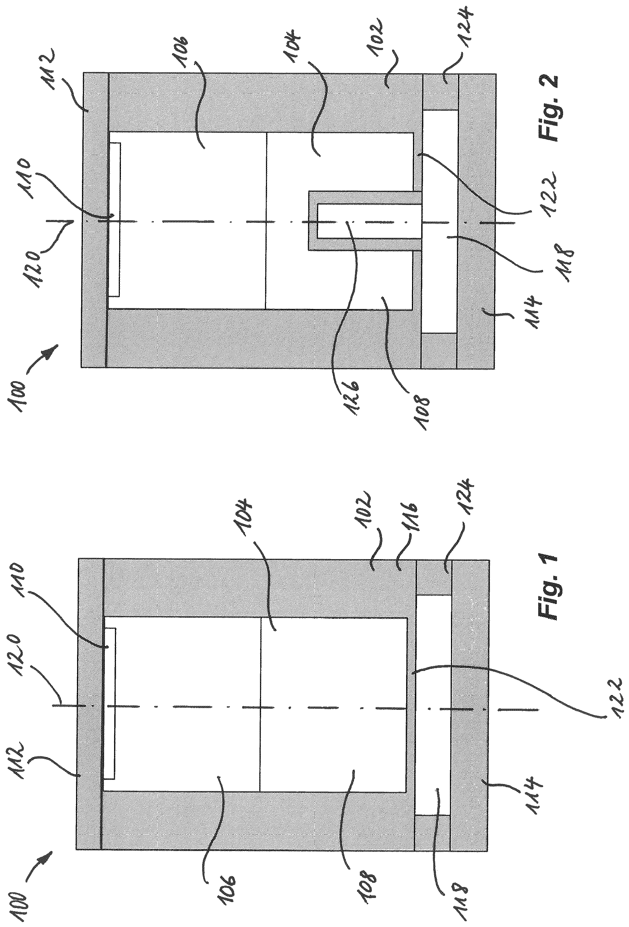

The present invention will now be explained in more detail with reference to the Figures and firstly referring to Fig. 1.

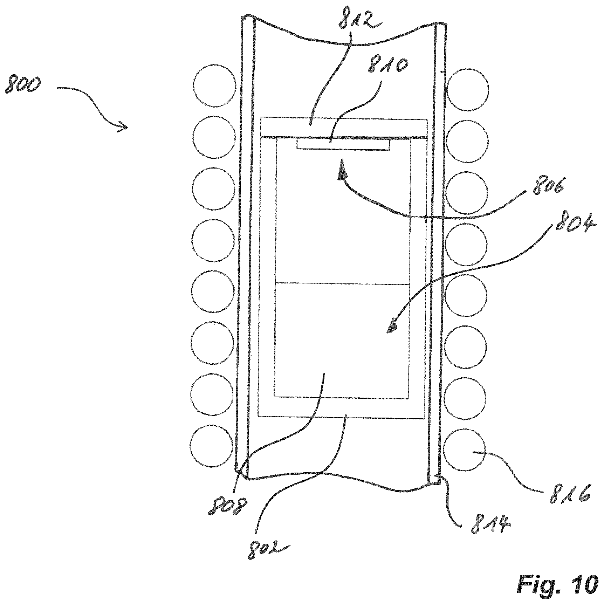

Fig. 1 shows a sublimation system 100 according to a first example of the present disclosure. It should be noted that the term sublimation system is intended to cover any system for growing at least one single crystal of a semiconductor material by means of a sublimation growing process. Preferably, the term refers to a physical vapor transport (PVT) system for growing silicon carbide (SiC) volume single crystals as described with reference to Fig. 10. Moreover, the heating system is not depicted in Figures 1 to 9 because its specific structure is not important for the gist of the present disclosure.

The sublimation system 100 comprises a growing crucible 102, which contains a source material compartment, in particular an SiC supply region 104 and a crystal growth region 106. Powdery SiC source material 108, which is poured as a pre-finished starting material before the beginning of the growth process into the SiC supply region 104 of the growing crucible 102, for example, is located in the SiC supply region 104. The source material 108 may also be densified or be at least partly consist of solid material in order to enhance the density of the source material 108.

A seed crystal 110 is provided on an inner wall opposing the SiC supply region 104 of the growing crucible 102, for instance on its crucible lid 112, in the crystal growth region 106. The bulk SiC single crystal to be grown grows on the seed crystal 110 by deposition from an SiC growth gas phase forming in the crystal growth region 106. The growing bulk SiC single crystal and the seed crystal 110 may have approximately the same diameter. The bulk SiC single crystal may also have a larger diameter than the seed crystal 110, if the diameter of the crystal channel is larger than the seed crystal 110. However, the usable low-defect diameter of the grown bulk SiC single crystal usually is the same size as the diameter of the seed crystal.

The growing crucible 102 including the crucible lid 112 may be fabricated from an electrically and thermally conductive graphite crucible material. Around it is arranged a thermal insulation (not shown in the Figure), which may comprise, for example, a foam-like graphite insulation material, the porosity of which is, in particular, higher than that of the graphite crucible material.

In case of an inductive heating, the thermally insulated growing crucible 102 is placed inside a tubular container (not shown in Fig. 1), which may be configured as a quartz glass tube and forms an autoclave or reactor. An inductive heating device in the form of a heating coil (not shown in the Figure) is arranged around the container to heat the growing crucible 102. The heating coil generates the required temperature field by inductively coupling an electric current into an electrically conductive crucible wall (the susceptor) of the growing crucible 102. This electric current flows substantially as a circulating current in the peripheral direction within the circular and hollow cylindrical crucible wall and in the process heat the growing crucible 102. The susceptor can be made from graphite, TaC, WC, Ta, W, or other refractory metals, and may either be an integral part of the crucible 102 or may be a separate part close to the crucible wall. The primary purpose of the susceptor is to provide a heat source for inside of the crucible 102. When the susceptor is heated with induction, the surface of the susceptor reaches a high temperature, and the temperature is then transferred to the inside of the crucible 102 through conduction and/or radiation.

As mentioned above, the coil is mounted outside the glass tube in case of an inductive heating and is usually surrounded by a Faraday cage (not visible in Fig. 1) to shield the electromagnetic radiation. In case of a resistive heating, a coil or another suitable heating means, such as a heating plate, is mounted within the reactor and also within the thermal insulation, thus being in close contact to the crucible 102. The principles of the present disclosure are applicable to both heating techniques. Thus, the coil will more generally be referred to as a heating means and encompasses inductive as well as resistive heating (or a combination thereof) in the following.

The temperature field created inside the crucible 102 is symmetrical radially around the central axis 120 and has a gradient driving the growth of the single crystal in a direction along the central axis 120.

As shown in Fig. 1, in a region opposite to the seed crystal 110 and adjacent to the source material compartment 104, the crucible 102 comprises a heating base 114. The heating base as well as the sidewall 116 are heated up by the heating means during the growth of the single crystal. According to the present disclosure, a first heat radiation cavity 118 is arranged opposite to the seed crystal 110 means and adjacent to the source material compartment 104, the first heat radiation cavity 118 being closed on all of its sides. During operation, the first heat radiation cavity 118 is filled with the working gas surrounding and filling the crucible 102. Usually, this is a mixture of inert gas and dopant, which according to the system pressure diffuses through the walls of the first heat radiation cavity 118 into the inner volume of the first heat radiation cavity 118.

From the source material compartment 104 the first heat radiation cavity 118 is separated by a separation wall 122. This separation wall 122 is fabricated from the same material as the remainder of the crucible 102.

According to the present disclosure, the first heat radiation cavity 118 transports heat via heat radiation from the heating base 114 towards the separation wall 122. Because the separation wall 122 is comparatively thin, the heat easily passes into the source material compartment 104, heating up the source material 108 in a radially homogenous manner.

The part of the sidewall 116 of the crucible 102, which delimits the first heat radiation cavity 118 is formed by a ring-shaped delimiting structure 124. Thus, it can be achieved that the first heat radiation cavity 118 may have a different diameter across the longitudinal axis 120 than the source material compartment 104. In the shown example, the first heat radiation cavity 118 extends in a direction across to the longitudinal axis further than the source material compartment 104. This allows for the source material 108 to be heated up more efficiently over the complete diameter of the source material compartment 104.

It could be shown that a particularly effective heating of the source material 108 can be achieved when providing a first heat radiation cavity 118 with an inner volume corresponding to at least 1 % of the inner volume of the source material compartment 104. The at least one heat radiation cavity 118 should specifically have a volume which equals at least 1 % and at most 20 % of a volume of the source material compartment 104, more specifically, the at least one first heat radiation cavity 118 may have a volume which equals at least 1 % and at most 18 %, preferably at most 16 %, of the volume of the source material compartment 104.

The source material compartment 104 is usually separated from the crystal growth chamber by a porous membrane. Thus, the volume of the source material compartment 104 is geometrically defined even with depleting source material. Also, when using solidified powder or a solid source material (e. g. polycrystalline or ceramic SiC), a sharp demarcation is given, if necessary, even without a membrane. When the SiC powder is converted into the graphite sponge, the original volume remains.

Fig. 2 shows a different example of the sublimation system 100 according to the present disclosure having a differently shaped first heat radiation cavity 118. It should be noted that the remaining features of the sublimation system 100 correspond to those of the sublimation system 100 shown in Fig. 1.

According to Fig. 2, the first heat radiation cavity 118 has a central protruding compartment 126, which extends along the longitudinal axis 120 into the source material compartment 104. Such protrusions allow to direct the heat more closely into the center of the source material compartment. Furthermore, the surface of the heating area is enlarged which in turn enhances the heating efficiency. The separation wall 122 is also in the area of the protruding compartment 126 relatively thin in order to facilitate the heat transport into the source material 108.

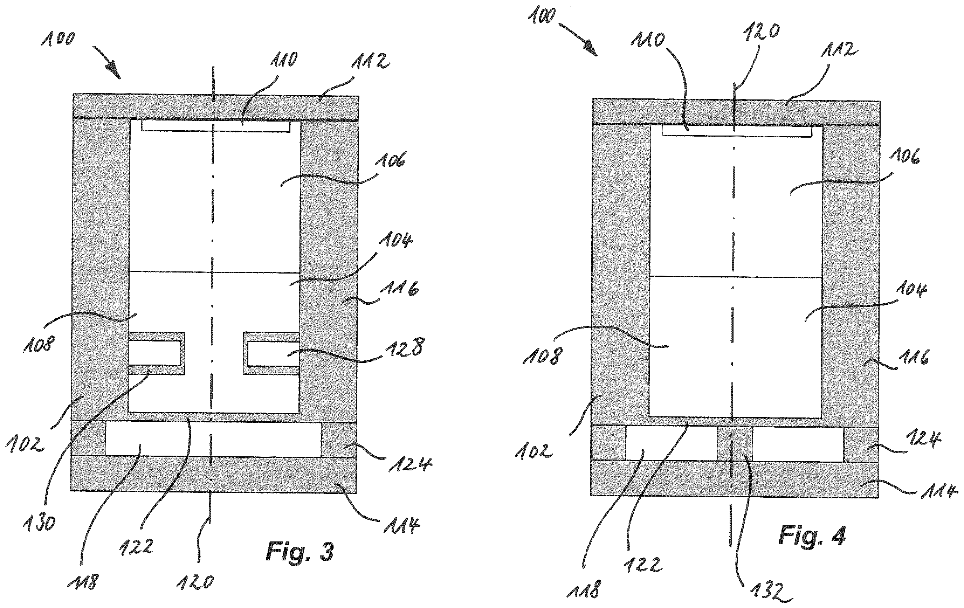

Fig. 3 shows another example of a sublimation system 100 according to the present disclosure, in which in addition to the first heat radiation cavity 118 a second heat radiation cavity 128 is provided. It should be noted that the remaining features of the sublimation system 100 correspond to those of sublimation system 100 shown in Fig. 1.

According to the example shown in Fig. 3, the second heat radiation cavity 128 extends from the sidewall 116 of the crucible 102 into the inner volume of the source material compartment 104. Along the longitudinal axis 120, the second heat radiation cavity 128 may for instance be arranged at an axial position corresponding to about the middle of the source material compartment 104. The second heat radiation cavity 128 as shown exemplarily in Fig. 3 is for instance ring shaped and has a second separation wall 130 with about the same thickness as the first separation wall 122. The second heat radiation cavity 128 guides the heat from the sidewall 116 via heat radiation into the source material 108. Thus, the second heat radiation cavity 128 allows locally influencing the temperature acting on the source material 108.

According to a further advantageous example of the present disclosure, the first heat radiation cavity 118 may comprise one or more pillars 132 connecting the heating base to the separation wall 122. This example is shown in Fig. 4.

As depicted in Fig. 4, one central pillar 132 is provided inside the first heat radiation cavity 118. At the position of the pillar 132 heat is not transported via heat radiation, but rather via heat conduction through the pillar 132. Therefore, a local reduction of the heat flux into the source material compartment 104 is achieved.

As described above, the different geometries serve to fine-tune the temperature in the powder as decoupled as possible from the temperature distribution determined by the global crucible geometry, in order to enable best crystal growth. An optimized powder conversion can be achieved with different geometries in the growth space.

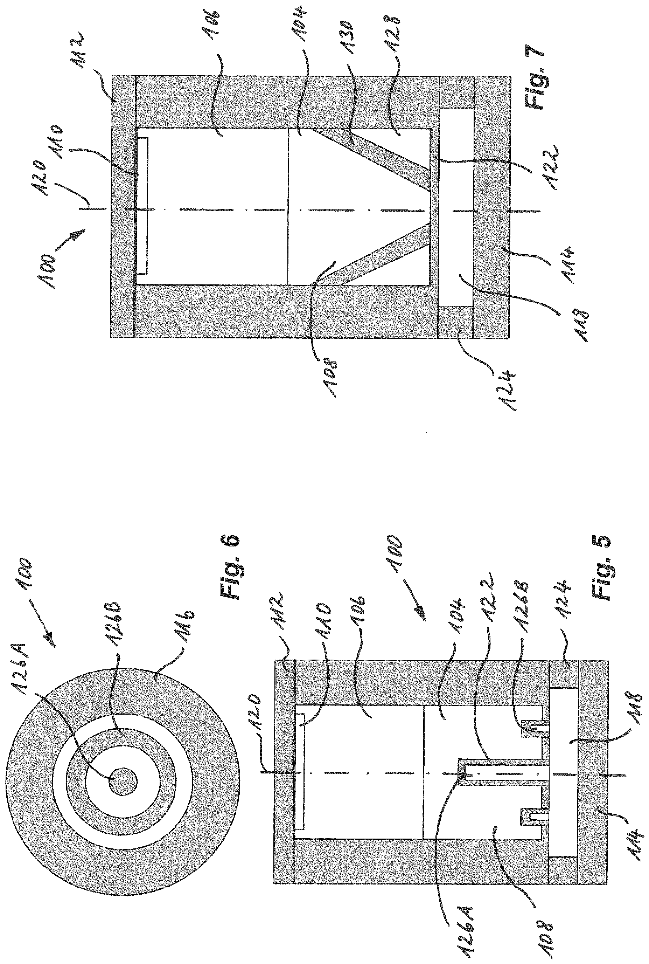

Fig. 5 and 6 show in a side view and corresponding schematic top view a further modification of the protruding compartment 126 of Fig. 2. The sublimation system 100 of Fig. 5 and 6 differs from the one shown in Fig. 2 in that not only one central protruding compartment 126A is extending into the source material compartment 104, but also by a second, exemplarily ring-shaped protruding compartment 126B is arranged around the central protruding compartment 126A. As with the geometry of Fig. 2, the advantage of this solution can be seen in allowing to direct the heat more closely into the center of the source material compartment. Furthermore, the surface of the heating area is enlarged which in turn enhances the heating efficiency. The separation wall 122 is also in the area of the protruding compartments 126A, 126B relatively thin in order to facilitate the heat transport into the source material 108.

It is clear that any other shape and number of the one or more protruding compartment 126 may of course also be used, if the desired heating pattern requires this.

In any case, the one or more protruding compartment 126 is in direct communication with the rest of the first heat radiation cavity 118. In other words, no distance or delimiting walls separate the inner volume of the one or more protruding compartment 126 from the inner volume of the rest of the first heat radiation cavity 118.

In contrast thereto, the second heat radiation cavity 128 shown in Fig. 3 has an inner volume that is separated from the inner volume of the first heat radiation cavity 118. Fig. 7 illustrates a modification of the second heat radiation cavity 128. According to this example, the second heat radiation cavity 128 is ring shaped with a slanted separation wall towards the source material compartment. The second heat radiation cavity 128 is formed by introducing a funnel shaped second separation wall 130 (forming essentially a frustum of a cone) into the bottom region of the source material compartment 104. The second heat radiation cavity 128 is arranged adjacent to the first heat radiation cavity 118, both cavities being separated from each other by a part of the first separation wall 122.

This arrangement has the advantage that the heat can be directed into the source material 108 even more efficiently. In particular, the peripheral bottom region of the source material compartment 104 can be heated by benefitting from heat radiation.

As described above, the different geometries serve to fine-tune the temperature in the powder as decoupled as possible from the temperature distribution determined by the global crucible geometry, in order to enable best crystal growth. An optimized powder conversion can be achieved with different geometries in the growth space.

In order to enhance the radiation mechanism in the middle of the source material compartment 104 and additionally reducing the amount of source material being disposed in the central region of the source material compartment, the second heat radiation cavity 128 may also be delimited by a cone shaped second separation wall 130. This example is illustrated in Fig. 8.

As described above, the different geometries serve to fine-tune the temperature in the powder as decoupled as possible from the temperature distribution determined by the global crucible geometry, in order to enable best crystal growth. An optimized powder conversion can be achieved with different geometries in the growth space.

In all the examples shown in Fig. 1 to 8, the first heat radiation cavity 118 was always shown to have a larger inner diameter than the inner diameter of the source material compartment 104. In contrast thereto, Fig. 9 shows an example of a sublimation system 100, in which the inner diameter of the first heat radiation cavity 118 is smaller than the inner diameter of the source material compartment 104.

Thus, the heat flux into the central region of the source material compartment 104 is higher than into the peripheral region of the source material compartment 104, where the heat flux is provided through the ring-shaped delimiting structure 124 via heat conduction.

In summary, the present disclosure is based on the idea of using hollow cavities in various positions of the region opposite to the seed crystal 110 for guiding the heat flux in a more defined and efficient manner into the source material compartment 104.

By selectively introducing a cavity that enables heat transport via radiation, a significantly lower temperature difference in the system can be achieved. In particular, at least one cavity is present on at least one side of the respective diffusion-determining surface of the source material facing away from the crystal for locally influencing the temperature distribution in the source material.

This makes it possible to transport the temperature, which is usually hottest in the wall area of the introduced crucible, to the center of the structure. A significant advantage of this is a much more efficient use of the available source material during the growth process. This also makes it possible to keep the gas phase composition constant for longer during cultivation, as the source material can be heated over a larger area and more homogeneously, thus avoiding quality losses due to a changing gas phase.

A resulting advantage is a significant increase in the effectively usable mass of source material for the growth of the crystal and thus a possible increase in length as well as quality.

It should also be noted, that some of the above explained exemplary structures according to Figures 1 to 9 or only parts thereof may be combined with each other arbitrarily.

REFERENCE NUMERALS

| Reference Numeral | Description |
|---|---|
| 100 | sublimation system; PVT system |
| 102 | crucible |
| 104 | SiC supply region; source material compartment |
| 106 | crystal growth region |
| 108 | source material |
| 110 | seed crystal |
| 112 | crucible lid |

(continued)

| Reference Numeral | Description |
|---|---|
| 114 | heating base |
| 116 | sidewall of crucible |
| 118 | first heat radiation cavity |
| 120 | central axis |
| 122 | (first) separation wall |
| 124 | ring-shaped delimiting structure |
| 126, 126A, 126B | protruding compartment |
| 128 | second heat radiation cavity |
| 130 | second separation wall |
| 132 | pillar |
| 800 | PVT system |
| 802 | crucible |
| 804 | SiC supply region |
| 806 | crystal growth region |
| 808 | source material |
| 810 | seed crystal |
| 812 | crucible lid |
| 814 | container; reactor |
| 816 | inductive heating coil |
| 1001 | heat flux via conduction |
| 1002 | heat flux via radiation |
| 1003 | temperature range relevant for the growth of SiC |

**Claims**

1.  Sublimation system for growing at least one single crystal of a semiconductor material by means of a sublimation growing process, the sublimation system (100) comprising:

    a crucible (102) having a longitudinal axis (120) and a sidewall (116) extending along the longitudinal axis (120), wherein the crucible comprises a fixing means for at least one seed crystal (110) and at least one source material compartment (104) for containing a source material (108), and
    a heating system being formed to generate a temperature field around a circumference of the crucible along the longitudinal axis of the crucible,
    wherein the crucible (102) comprises at least one first heat radiation cavity (118), which is arranged opposite to the fixing means and adjacent to the source material compartment (104), the first heat radiation cavity (118) being closed on all of its sides.

2.  Sublimation system according to claim 1, wherein the at least one first heat radiation cavity (118) is delimited against the source material compartment (104) by a first separation wall (122) which is formed from the same material as the sidewall (116) of the crucible (102).

3.  Sublimation system according to claim 1 or 2, wherein the first heat radiation cavity (118) has an inner diameter across the longitudinal axis (120) which is larger than an inner diameter of the source material compartment.

4. Sublimation system according to one of the preceding claims, wherein the at least one first heat radiation cavity (118) is delimited against the source material compartment (104) by a first separation wall (122) which is thinner than the sidewall (116) of the crucible (102) and thinner than walls (124, 114) that delimit the remaining sides of the first heat radiation cavity (118).

5. Sublimation system according to one of the preceding claims, wherein the first heat radiation cavity (118) has at least one protruding compartment (126), which extends along the longitudinal axis (120) into the source material compartment (104).

6. Sublimation system according to one of the preceding claims, wherein at least one second heat radiation cavity (128) is arranged inside the source material compartment (104), the at least one second heat radiation cavity (128) being separate from the first heat radiation cavity (118).

7. Sublimation system according to claim 6, wherein the at least one second heat radiation cavity (128) is ring shaped with a center axis of the ring coinciding with the longitudinal axis of the crucible.

8. Sublimation system according to claim 6 or 7, wherein the at least one second heat radiation cavity (128) is delimited against the source material compartment (104) by a slanted separation wall (130) that includes an angle with the longitudinal axis (120).

9. Sublimation system according to claim 8, wherein the at least one second heat radiation cavity (128) is delimited against the source material compartment (104) by a cone-shaped separation wall (130).

10. Sublimation system according to one of the preceding claims, wherein the first heat radiation cavity (118) is provided with a solid pillar (132) penetrating the first heat radiation cavity (118) in a direction along the longitudinal axis (120).

11. Sublimation system according to one of the preceding claims, wherein the heating system comprises an induction coil operable to generate an electro-magnetic field and/or a resistive heater, at least partly surrounding the crucible (102).

12. Sublimation system according to one of the preceding claims, wherein the at least one first heat radiation cavity (118) has an inner volume which equals at least 1 % and at most 20 % of a volume of the source material compartment.

13. Sublimation system according to claim 12, wherein the at least one first heat radiation cavity (118) has an inner volume which equals at least 1 % and at most 18 %, preferably at most 16 %, of the volume of the source material compartment.

14. Method of growing at least one single crystal of a semiconductor material by means of a sublimation growing process, the method comprising:

   providing a crucible (102) having a longitudinal axis (120) and a sidewall (116) extending along the longitudinal axis (120), fixing at least one seed crystal (110) at a fixing means of the crucible (102), and filling a source material (108) into at least one source material compartment (104);
   generating, by means of a heating system, a temperature field around a circumference of the crucible (102) and along the longitudinal axis (120) of the crucible (102);
   wherein the heat of the temperature field is coupled via heat radiation into the source material compartment through at least one first heat radiation cavity (118), which is arranged opposite to the fixing means and adjacent to the source material compartment (104), the heat radiation cavity (118) being closed on all of its sides.

15. Method according to claim 12, wherein in a plane extending across to the longitudinal axis (120) and opposite to the seed crystal (110), which has a maximum temperature within the source material compartment, no temperature differences of more than 20 K, preferably no temperature differences of more than 15 K, more preferably no temperature differences of more than 10 K, occur.

Fig. 1

Fig. 2

Fig. 4

Fig. 3

Fig. 7

Fig. 6

Fig. 5

Fig. 9

Fig. 8

Fig. 10

*Fig. 11*

Europäisches
Patentamt

European
Patent Office

Office européen
des brevets

# EUROPEAN SEARCH REPORT

Application Number

EP 23 16 1963

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/255568 A1 (INOUE HIROKI [JP] ET AL) 3 October 2013 (2013-10-03) | 1,2,5, 11-15 | INV. C30B23/06 |
| A | * figure 2 * <br> * paragraphs [0031] - [0043] * | 6-9 | C30B29/36 |
| X | WO 2010/077639 A2 (II VI INC [US]; RENGARAJAN VARATHARAJAN [US] ET AL.) 8 July 2010 (2010-07-08) | 1,2, 11-15 | |
| Y | * figures 5, 6 * | 10 | |
| A | * pages 57-69 * <br> * claims 10-15 * | 6-9 | |
| X | US 2016/002820 A1 (HORI TSUTOMU [JP] ET AL) 7 January 2016 (2016-01-07) | 1,2,4, 11-15 | |
| A | * figures 1-7 * <br> * paragraphs [0030] - [0052] * <br> * claims 10-12 * | 6-9 | |
| X | US 2020/224328 A1 (FUJIKAWA YOHEI [JP]) 16 July 2020 (2020-07-16) | 1-4, 11-15 | |
| A | * figures 2, 3, 5 * <br> * paragraphs [0035] - [0045], [0055] - [0060] * <br> * page 5 * | 6-9 | TECHNICAL FIELDS SEARCHED (IPC) <br><br> C30B |
| Y | US 2016/032487 A1 (UETA SHUNSAKU [JP] ET AL) 4 February 2016 (2016-02-04) * figures 1, 5, 6 * * paragraphs [0015] - [0019], [0037] * | 10 | |

The present search report has been drawn up for all claims

| Place of search | Date of completion of the search | Examiner |
|---|---|---|
| The Hague | 19 July 2023 | Schmitt, Christian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 1963

This annex lists the patent family members relating to the patent documents cited in the above-mentioned European search report.
The members are as contained in the European Patent Office EDP file on
The European Patent Office is in no way liable for these particulars which are merely given for the purpose of information.

19-07-2023

| Patent document cited in search report | Publication date | Patent family member(s) | Publication date |
|---|---|---|---|
| US 2013255568 A1 | 03-10-2013 | JP 2013212952 A | 17-10-2013 |
| | | US 2013255568 A1 | 03-10-2013 |
| WO 2010077639 A2 | 08-07-2010 | CN 102245813 A | 16-11-2011 |
| | | CN 104120489 A | 29-10-2014 |
| | | DE 112009003667 T5 | 11-10-2012 |
| | | JP 5406936 B2 | 05-02-2014 |
| | | JP 2012510951 A | 17-05-2012 |
| | | SE 1150634 A1 | 05-07-2011 |
| | | US 2010139552 A1 | 10-06-2010 |
| | | US 2016097143 A1 | 07-04-2016 |
| | | WO 2010077639 A2 | 08-07-2010 |
| US 2016002820 A1 | 07-01-2016 | CN 105239157 A | 13-01-2016 |
| | | DE 102015212323 A1 | 07-01-2016 |
| | | US 2016002820 A1 | 07-01-2016 |
| US 2020224328 A1 | 16-07-2020 | CN 111424311 A | 17-07-2020 |
| | | JP 7286970 B2 | 06-06-2023 |
| | | JP 2020111481 A | 27-07-2020 |
| | | US 2020224328 A1 | 16-07-2020 |
| US 2016032487 A1 | 04-02-2016 | JP 5892209 B2 | 23-03-2016 |
| | | JP 2016034880 A | 17-03-2016 |
| | | US 2016032487 A1 | 04-02-2016 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 8865324 B2
- US 20160138185 A1
- US 20170321345 A1
- CN 210974929 U
- JP 6859800 B
- JP 6501494 B